**Europäisches Patentamt**

**European Patent Office**

**Office européen des brevets**

(19)

(11) Veröffentlichungsnummer: **0 043 489**
**B1**

(12) EUROPÄISCHE PATENTSCHRIFT

(45) Veröffentlichungstag der Patentschrift:
16.05.84

(51) Int. Cl.³: **H 03 K 17/10**

(21) Anmeldenummer: **81104791.9**

(22) Anmeldetag: **22.06.81**

(54) **Schalter mit in Serie geschalteten MOS-FET.**

(30) Priorität: **09.07.80 DE 3026040**

(43) Veröffentlichungstag der Anmeldung:
**13.01.82 Patentblatt 82/2**

(45) Bekanntmachung des Hinweises auf die Patenterteilung:
**16.05.84 Patentblatt 84/20**

(84) Benannte Vertragsstaaten:
**AT CH FR GB IT LI NL SE**

(56) Entgegenhaltungen:
DE - A - 2 352 654
GB - A - 1 341 334
US - A - 2 048 518
US - A - 4 069 430

ELECTRONICS DESIGN, Band 24, Nr. 9, 26. April 1976,
ROCHELLE PARK (US), L. SHAEFFER: "Use FETs to
switch high currents", Seiten 66-72
ELECTRONICS, Band 49, Nr. 13, 24. Juni 1976, NEW
YORK (US), M. VANDER KOOI et al.: "MOS moves into
higher-power applications", Seiten 98-102
ELECTRONIC DESIGN, Band 25, Nr. 17, August 1977,
ROCHELLE PARK (US), M.J. SALVATTI: "Logic
interfacing circuit translates many levels to TTL
regardless of polarity", Seite 106
MICROELECTRONICS, Band 2, Nr. 7, Juli 1969, LUTON

(73) Patentinhaber: **SIEMENS AKTIENGESELLSCHAFT,
Berlin und München Wittelsbacherplatz 2,
D-8000 München 2 (DE)**

(72) Erfinder: **Stengl, Jens-Peer, Gunterstrasse 13,
D-8000 München 19 (DE)**
Erfinder: **Thomas, Hartmut, Königsteinstrasse 3,
D-8000 München 40 (DE)**
Erfinder: **Tihanyi, Jenö, Dr., Wolfratshauserstrasse 179 b,
D-8000 München 71 (DE)**

(56) Entgegenhaltungen: (Fortsetzung)
(GB), "16-channel analogue multiplexer combines
integrated J/FETs and bipolar transistors", Seite 9

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Schalter mit in Serie geschalteten MOS-FET

Die Erfindung bezieht sich auf einen Schalter mit mindestens zwei in Serie geschalteten MOS-FET, bei dem der Drain-Anschluß des vorhergehenden MOS-FET mit dem Source-Anschluß des darauffolgenden MOS-FET verbunden ist und die Steueranschlüsse der MOS-FET an eine Steuerspannungsquelle anschließbar sind.

Solche Schalter werden zum Schalten von Spannungen eingesetzt, die höher als die Durchbruchsspannung, also höher als die maximale Sperrspannung eines einzelnen MOS-FET sind. In der Zeitschrift »Elektronics«, Juni 24, 1976, Seite 101, Fig. 5b ist ein solcher Schalter beschrieben. Er bezieht seine Ansteuerleistung im geöffneten Zustand aus einem kapazitiven Spannungsteiler, der an einer festen Spannung liegt. Die Steuerspannung wird mit einem Logikkreis geschaltet, dem eine gesonderte Stromquelle zugeordnet ist. Zum Schalten des Logikkreises muß wiederum eine Steuerspannungsquelle vorgesehen sein.

Die beschriebene Ansteuerschaltung erfordert daher einen nicht unbeträchtlichen Aufwand. Der Erfindung liegt die Aufgabe zugrunde, einen Schalter der eingangs erwähnten Art mit weniger Aufwand aufzubauen.

Die Erfindung ist dadurch gekennzeichnet, daß der Steueranschluß des ersten MOS-FET direkt an eine Klemme der Steuerspannungsquelle anschließbar ist, daß der Steueranschluß der folgenden MOS-FET mit dem Steueranschluß jeweils der vorhergehenden MOS-FET über eine Diode verbunden ist, die bezüglich der Steuerspannungsquelle in Durchlaßrichtung gepolt ist, und daß zwischen dem Steueranschluß und dem Source-Anschluß des zweiten und jedes weiteren MOS-FET je ein Widerstand liegt.

In der DE-A-23 52 654 ist bereits ein Hochspannungsschaltkreis mit mindestens zwei in Serie geschalteten bipolaren Transistoren beschrieben worden. Diese Transistoren werden durch Ansteuern des ersten bipolaren Transistors in schneller Folge nacheinander eingeschaltet. Dazu sind jeweils die Kollektoranschlüsse des vorhergehenden Transistors über einen Widerstand mit dem Basisanschluß des nächsten bipolaren Transistors verbunden. Die Funktion dieser Serienschaltung beruht darauf, daß im Ruhezustand ein geringer Kollektor-Basisstrom in jedem Transistor fließt. Diese Voraussetzung kann jedoch in einer Serienschaltung von MOS-FET nicht erfüllt werden, da abgesehen von geringen kapazitiven Drain-Gateströmen beim Schalten kein Stromfluß zwischen Drain und Gate möglich ist. Die bekannte, für Bipolartransistoren anwendbare Lösung ist daher nicht auf MOS-FET übertragbar.

Weiterbildungen der Erfindung sind Gegenstand der Unteransprüche.

Die Erfindung wird an Hand dreier Ausführungsbeispiele in Verbindung mit den Fig. 1 bis 3 näher erläutert. Es zeigt

Fig. 1 einen Schalter mit mindestens zwei MOS-FET gemäß einem ersten Ausführungsbeispiel,

Fig. 2 einen Schalter mit zwei MOS-FET gemäß einem zweiten Ausführungsbeispiel und

Fig. 3 einen Schalter gemäß einem dritten Ausführungsbeispiel.

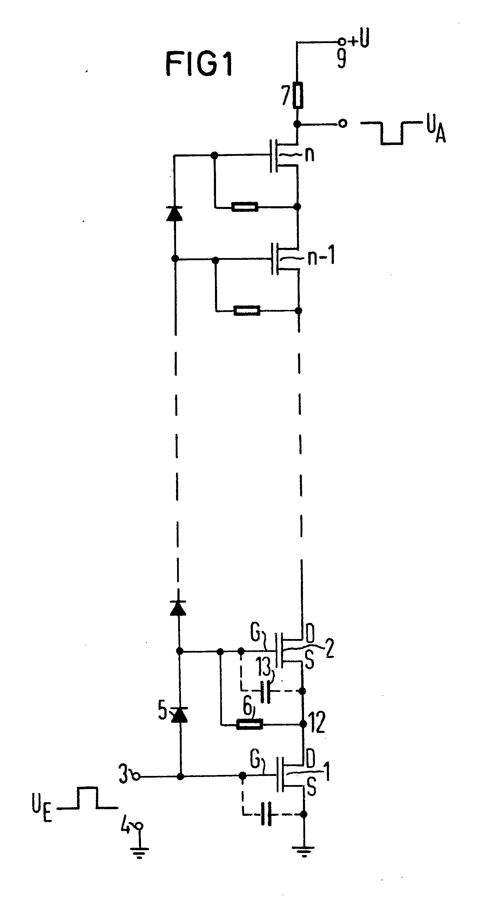

Der Schalter nach Fig. 1 weist mindestens zwei in Serie geschaltete Leistungs-MOS-FET 1 und 2 auf, wobei der Drain-Anschluß D des FET 1 mit dem Source-Anschluß S des FET 2 verbunden ist. Der Steueranschluß G des FET 1 ist mit einer Eingangsklemme 3 verbunden. Eine zweite Eingangsklemme 4 liegt auf dem Potential des Source-Anschlusses S. Der Steueranschluß G des FET 1 ist über eine Diode 5 mit dem Steueranschluß des FET 2 verbunden. Die Diode hat eine Sperrspannung, die mindestens so groß ist wie die Durchbruchsspannung $U_{BD}$ des FET 2. Der Steueranschluß des zweiten FET 2 ist mit seinem Source-Anschluß über einen Widerstand 6 elektrisch verbunden. Der Verbindungspunkt des Widerstands 6 mit dem Source-Anschluß ist mit 12 bezeichnet. Parallel zum Widerstand liegt die Eingangskapazität 13 des FET 2, die symbolisch durch gestrichelte Anschlüsse dargestellt ist.

Für höhere Sperrspannungen können weitere MOS-FET in Serie geschaltet werden, wie es durch die FET n — 1 und n angedeutet ist. In Serie mit den FET liegt ein Lastwiderstand 7, der über eine Klemme 9 mit einer positiven Versorgungsspannung +U verbunden ist.

Wird an die Eingangsklemmen 3, 4 ein positiver Spannungsimpuls $U_E$ von zum Beispiel 5 V angelegt, so wird der erste FET 1 geöffnet, wenn seine Eingangskapazität 13 mindestens auf die Einsatzspannung aufgeladen ist. Wird der FET 1 leitend, so sinkt das Potential am Punkt 12 ab. Ist das Potential am Punkt 12 so weit abgesunken, daß das Potential am Steueranschluß G des FET 2 niedriger als die Eingangsspannung $U_E$ zuzüglich der Schwellspannung der Diode 5 ist, so wird die Diode 5 leitend und die Kapazität 13 wird aufgeladen. Überschreitet die Spannung in der Kapazität 13 die Einsatzspannung des FET 2, so wird dieser ebenfalls leitend. Dieser Vorgang setzt sich fort, bis auch der letzte der in Serie geschalteten FET leitend gesteuert ist. Dann liegt am Lastwiderstand 7 die volle Ausgangsspannung $U_A$ an. Da die Einschaltzeit eines einzelnen Leistungs-MOS-FET bei zum Beispiel 500 V Sperrspannung in der Größenordnung 100 ns liegt, läßt sich ein schnelles Einschalten des Schalters auch bei einer großen Anzahl in Serie geschalteter MOSFET erzielen.

Zum Abschalten des Schalters wird die Eingangsspannung ausgeschaltet, wodurch das FET 1 gesperrt wird. Damit steigt das Potential am Punkt 12, die Diode 5 wird gesperrt und die Eingangskapazität 13 kann sich über den Widerstand 6 entladen. Sinkt die Spannung an der Eingangskapazität 13 unter die Einsatzspannung, sperrt auch der FET 2. Zur Erzielung einer kurzen Ausschaltzeit muß der Widerstand 6 so klein gewählt werden, daß die Kapazität 13 in einer Zeit entladen wird, die klein gegen die Periode des Schaltzyklus ist. Andererseits muß der Widerstand 6 jedoch so groß sein, daß der durch die Diode 5 fließende Steuerstrom einen zum Öffnen des FET 2 ausreichenden Spannungsabfall erzeugt. Als Beispiel für einen Schalter für 1000 V mit zwei FET von je 500 V Sperrspannung wurde der Widerstand 6 mit 100 Ohm bemessen. Bei einer Größe der Kapazität 13 von 5 nF läßt sich damit eine Schaltfrequenz von etwa 100 kHz erreichen.

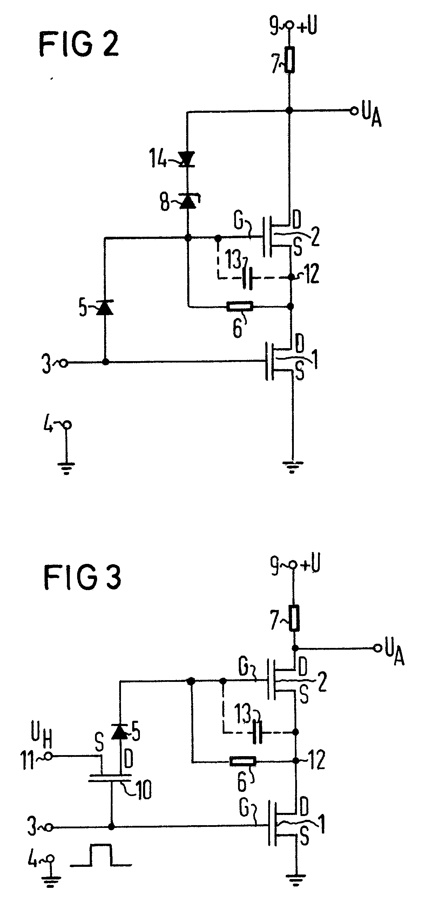

Voraussetzung für die Funktion des Schalters nach Fig. 1 ist, daß der beim Einschalten noch gesperrte Transistor oder die beim Einschalten noch gesperrten Transistoren die an ihnen anliegende Spannung und den fließenden Strom auch dann aushalten, wenn sie in den Lawinendurchbruch gehen. Wenn im Durchbruch der Strom nicht ausgehalten würde, kann der Schalter leicht modifiziert werden, wie dies in Fig. 2 dargestellt ist. Dieser Schalter unterscheidet sich von dem nach Fig. 1 durch eine zwischen dem Drain-Anschluß und dem Steueranschluß des FET 2 liegende Zenerdiode 8, der eine Diode 14 in Antiserie geschaltet ist. Diese Zenerdiode hat eine Zenerspannung, die ein wenig kleiner ist (zum Beispiel 480 V), als die Durchbruchsspannung des FET 2. Wird an die Eingangsklemmen 3, 4 eine Eingangsspannung gelegt, so wird der FET 1 leitend gesteuert. Damit sinkt das Potential am Punkt 12 ab und ein Strom kann über den Lastwiderstand 7 durch die Zenerdiode 8 zum Punkt 12 fließen. Die Zenerdiode 8 bricht dann sofort durch, und der Durchbruchsstrom durch die Zenerdiode 8 erzeugt im Widerstand 6 einen Spannungsabfall, der die Eingangskapazität des FET 2 auflädt. Beim Überschreiten der Einsatzspannung wird dann der FET 2 leitend, ohne daß die gesamte Betriebsspannung an ihm anliegt. Beim Absinken der am FET 2 liegenden Spannung unter die Zenerspannung sperrt die Zenerdiode 8 und der FET 2 wird über die Diode 5 leitend gehalten.

Beim Abschalten des Schalters wird der FET 1 gesperrt und die Zenerdiode 8 geht in den Sperrzustand über. Die Diode 5 wird ebenfalls gesperrt und die Eingangskapazität kann sich über den Widerstand 6 entladen. Damit wird auch der FET 2 gesperrt.

Um die Steuerspannungsquelle leistungsmäßig zu entlasten, kann die den Klemmen 3, 4 zugeführte Steuerspannung dazu benutzt werden, einen Hilfs-MOS-FET 10 anzusteuern, wie dies in Fig. 3 dargestellt ist. Der Source-Anschluß des Hilfs-MOS-FET 10 liegt an einer Klemme 11, an die eine Hilfsspannung $+U_H$ angeschlossen ist. Der Drain-Anschluß des Hilfs-FET 10 ist mit der Diode 5 verbunden. Bei Anlegen einer positiven Steuerspannung an die Klemmen 3, 4 wird der FET 1 und der Hilfs-FET 10 geöffnet. Durch die Diode 5 kann dann ein zum Aufladen der Eingangskapazität des FET 2 benötigter Strom fließen, wenn das Potential am Punkt 12 genügend weit abgesunken ist. Mit dieser Schaltungsanordnung lassen sich ebenfalls mehrere in Serie geschaltete MOS-FET einschalten. Das Ausschalten erfolgt auf gleiche Weise wie in Verbindung mit Fig. 1 und 2 beschrieben.

## Patentansprüche

1. Schalter mit mindestens zwei in Serie geschalteten MOS-FET, bei dem der Drain-Anschluß des vorhergehenden MOS-FET mit dem Source-Anschluß des darauffolgenden MOS-FET verbunden ist und die Steueranschlüsse der MOS-FET an einer Steuerspannungsquelle anschließbar sind, dadurch gekennzeichnet, daß der Steueranschluß (G) des ersten MOS-FET (1) direkt an eine Klemme der Steuerspannungsquelle anschließbar ist, daß der Steueranschluß der folgenden MOS-FET (2 ... n − 1; n) mit dem Steueranschluß jeweils des vorhergehenden MOS-FET über eine Diode (5) verbunden ist, die bezüglich der Steuerspannungsquelle in Durchlaßrichtung gepolt ist, und daß zwischen dem Steueranschluß (G) und dem Source-Anschluß (S) des zweiten (2) und jedes weiteren MOS-FET je ein Widerstand (6) liegt.

2. Schalter nach Anspruch 1, dadurch gekennzeichnet, daß die Sperrspannung der Diode (5) mindestens so groß wie die Sperrspannung des MOS-FET (2) ist.

3. Schalter nach Anspruch 1 oder 2, dadurch gekennzeichnet, daß zwischen dem Steueranschluß (G) und dem Drain-Anschluß (D) des zweiten FET (2) und der folgenden FET je eine Zenerdiode (8) liegt, die bezüglich der Versorgungsspannung in Sperrichtung gepolt ist und deren Zenerspannung kleiner als die Sperrspannung des zweiten FET (2) ist, und daß der Zenerdiode (8) eine weitere Diode (14) in Reihe geschaltet ist, deren Flußrichtung der Zenerdiode (8) entgegengesetzt ist.

4. Schalter nach einem der Ansprüche 1 bis 3, dadurch gekennzeichnet, daß die Diode (5) des zweiten FET (2) mit dem Drain-Anschluß eines Hilfs-FET (10) und der Steueranschluß des ersten FET (1) mit dem Steueranschluß des Hilfs-FET (10) verbunden ist, und daß der Source-Anschluß des Hilfs-FET (10) an einer Klemme (11) einer Hilfsspannungsquelle ($U_H$) liegt.

## Claims

1. A switch having at least two series-connected MOS-FETs, in which the drain connection of the preceding MOS-FET is connected to the source connection of the following MOS-FET and the gate connections of the MOS-FETs can be connected to a control voltage source, characterized in that the gate connection (G) of the first MOS-FET (1) can be directly connected to a terminal of the control voltage source; that the gate connection of the following MOS-FETs (2 ... n − 1; n) is connected in each case to the gate connection of the preceding MOS-FET by way of a diode (5) which with respect to the control voltage source is connected in the forward direction; and that, between the gate connection (G) and the source connection (S) of the second (2) and each succeeding MOS-FET, there is arranged a respective resistor (6).

2. A switch according to claim 1, characterized in that the reverse voltage of the diode (5) is at least as high as the reverse voltage of the MOS-FET (2).

3. A switch according to claim 1 or claim 2, characterized in that, between the gate connection (G) and the drain connection (D) of the second FET (2) and the following FETs, there is in each case arranged a Zener diode (8) which with respect to the supply voltage is connected in the reverse direction and the Zener voltage of which is lower than the reverse voltage of the second FET (2); and that the Zener diode (8) is connected in series with a further diode (14), the forward direction of which is opposite to that of the Zener diode.

4. A switch according to one of claims 1 to 3, characterized in that the diode (5) of the second FET (2) is connected to the drain connection of an auxiliary FET (10) and the gate connection of the first FET (1) is connected to the gate connection of the auxiliary FET (10); and that the source connection of the auxiliary FET (10) is connected to a terminal (11) of an auxiliary voltage source (U_H).

**Revendications**

1. Commutateur à au moins deux MOS-FET montés en série, du type dans lequel la borne de drain du MOS-FET précédent est reliée à la borne de source du MOS-FET suivant alors que les bornes de grille des MOS-FET sont susceptibles d'être reliées à une source de tension de commande, caractérisé par le fait que la borne de grille (G) du premier MOSFET (1) est susceptible d'être reliée directement à une borne de la source de tension de commande, que la borne de grille des MOS-FET suivants (2 ... n − 1; n) est reliée à la borne de grille du MOS-FET précédent par l'intermédiaire d'une diode (5) qui est montée, par rapport à la source de tension de commande, dans le sens direct, et qu'entre la borne de grille (G) et la borne de source (S) du second (2) et de chacun des autres MOS-FET, est située une résistance (6).

2. Commutateur selon la revendication 1, caractérisé par le fait que la tension de blocage de la diode (5) est au moins aussi grande que la tension de blocage du MOS-FET (2).

3. Commutateur selon la revendication 1 ou 2, caractérisé par le fait qu'entre la borne de grille (G) et la borne de drain (D) du second FET (2) et des FET suivants, est située une diode Zener (8) qui, par rapport à la tension d'alimentation, est montée dans le sens de blocage, et dont la tension Zener est inférieure à la tension de blocage du second FET (2) et qu'en série avec la diode Zener (8) est montée une seconde diode (14) dont le sens de passage est en sens inverse de celui de la diode Zener (8).

4. Commutateur selon l'une des revendications 1 à 3, caractérisé par le fait que la diode (5) du second FET (2) est reliée à la borne de drain d'un FET auxiliaire (10) alors que la borne de grille du premier FET (1) est reliée à la borne de grille du fait auxiliaire (10), et que la borne de source du FET auxiliaire (10) est reliée à une borne (11) d'une source de tension auxiliaire (U_H).

FIG 1

FIG 2

FIG 3